# EUROPEAN PATENT APPLICATION

(11) **EP 1 132 981 A2**
(43) Date of publication of application: **12.09.2001**
(21) Application number: 01105684.3
(22) Date of filing: 07.03.2001
(51) Int. Cl.: H01L 51/20

(54) **Organic el display apparatus**

(30) Priority: 10.03.2000 JP 2000066445
(71) Applicant: Autonetworks Technologies, Ltd., Nagoya-shi, Aichi (JP); Sumitomo Wiring Systems, Ltd., Yokkaichi-shi Mie-ken (JP); SUMITOMO ELECTRIC INDUSTRIES, LTD., Osaka-shi, Osaka (JP)
(72) Inventor: Ono, Junicho, c/o Autonetworks Technologies Ltd., Nagoya-shi, Aichi (JP)
(74) Representative: Kuhnen & Wacker

(57) **Abstract**

In an organic EL display apparatus 1A, a transparent electrode 4 is formed on the rear surface 3 of a substrate so as to be divided into plural portions respectively corresponding to light emitting areas 9. An opaque metal film 8 is divided into plural portions so as to form window portions 5 which define light emitting areas 9 on the respective transparent electrodes 4. A metal reflection film 20 is formed between the metal films 8 so as not to electrically connect the metal films 8 to each other. An opaque back electrode 11 is formed on an organic layer 10 laminated on the reflection film in a divided manner in correspondence with the divided metal films 8. The reflection film 20 covers at least a dividing slit 17 between the back electrodes 11.

## Description

### BACKGROUND OF THE INVENTION

### 1. Field of the Invention

The present invention relates to an organic EL (electroluminescence) display apparatus and, more particularly, relates to a technique which can prevent the occurrence of such a phenomenon that, in the case where an opaque back electrode constituting an organic EL element is divided into plural portions, an external light beam incident from the display surface thereof is mirror-reflected by the back electrodes thus divided and so a divided pattern of the back electrodes is displayed on the display surface due to the reflection light beam, thereby degrading the visibility of an image displayed on the display surface. Further, the invention relates to a technique which can also prevent the occurrence of such a phenomenon that, in the case where an opaque metal film is coated on an organic layer to design a light emitting area, a part of a light beam emitted from the organic layer enters between the back electrode and the metal film, then is : irror-reflected by the back electrode and the metal film, then introduced to the peripheral area of the metal film and leaked to the outside from an area except for the light emitting area of the display surface thereby to degrade the display quality.

### 2. Description of the Related Art

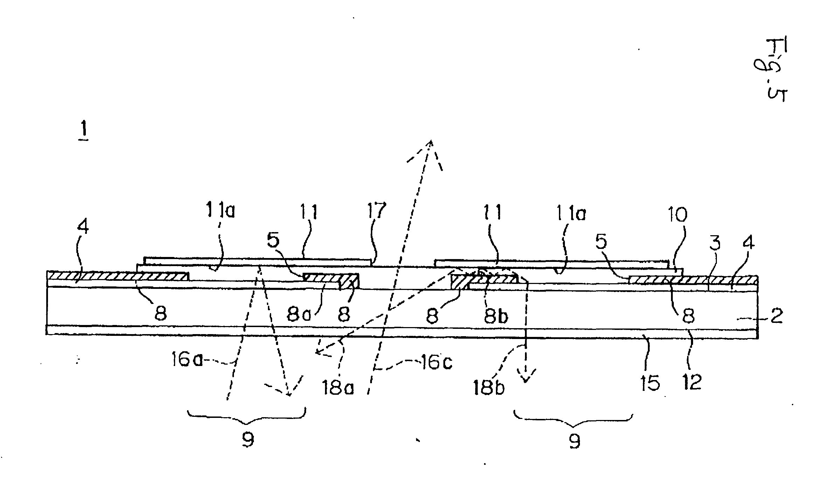

Fig. 5 shows a sectional view of a conventional organic EL display apparatus. As shown in Fig. 5, in the organic EL display apparatus 1, an organic EL element is configured in a manner that a transparent electrode 4 serving as an anode divided in plural portions is formed on the rear surface 3 of a transparent substrate 2, then an opaque metal film 8 is coated on the transparent electrode so as to form window portions 5 which define light emitting areas 9, then an organic layer 10 is laminated thereon so as to cover the window portions 5, and opaque back electrodes 11 serving as cathodes are laminated on the window portions 5 in a distributed,manner. Then, the organic EL display apparatus is formed by disposing a filter 15 on the front surface (display surface) of the transparent substrate 2 of the organic EL elements.

The filter 15 is provided to shield an external light beam 16a, which is incident from the display surface 12 within the organic EL display apparatus 1 and mirror-reflected by the front surfaces 8a and lla of the metal film 8 and the back electrode 11 and then going to be radiated to the outside from the display surface 12, so as not to be radiated to the outside from the display surface 12, thereby to prevent the degradation of the display quality due to the external light beam 16a being leaked to the outside from the display surface 12.

As the driving method of such an organic EL display apparatus 1, it is considered effective to employ the time division driving method so as to simplify a driving circuit of the apparatus. To this end, the back electrode 11 is divided into plural portions.

However, according to the organic EL display apparatus 1 configured in this manner, even if the filter 15 is employed in the aforesaid manner, it is impossible to completely shield the external light beam 16a which is incident from the display surface 12 and mirror-reflected and then going to be radiated to the outside. Thus, the external light beam is radiated to the outside from the display surface 12 in an attenuated state in its light intensity. Accordingly, in the case where the back electrode 11 is divided into plural portions, the external light beam 16a incident into an area of the display surface 12 corresponding to the back electrode 11 is mirror-reflected by the front surface lla of the back electrode 11 or the front surface 8a of the metal film 8 and radiated from the display surface 12. In contrast, an external light beam 16c incident into an area of the display surface 12 corresponding to the dividing slit 17 (a portion where the back electrode 11 does not exist) between the back electrodes 11 is not mirror-reflected by the back electrode 11 nor the metal film 8, and so the external light beam 16c is not radiated from the display surface 12 at all. As a result, the area of the display surface corresponding to the back electrode 11 is displayed more brightly than the area of the display surface corresponding to the dividing slit 17. That is, there arises a drawback that a divided pattern of the back electrodes 11 is displayed on the display surface 12 to thereby degrade the visibility of an image displayed on the display surface 12.

Further, there arises another drawback that, when the organic layer 10 emits light, a part 18a of the emitted light beams 18a, 18b is incident between the back electrode 11 and the metal film 8 and mirror-reflected by the front surface 11a of the back electrode 11 and the rear surface 8b of the metal film 8 and then induced to the peripheral area of the metal film 8 and leaked to the outside from an area except for the light emitting area 9 of the display surface, thereby degrading the display quality.

### SUMMARY OF THE INVENTION

Accordingly, an object of the invention is to provide an organic EL display apparatus which can prevent the occurrence of such a phenomenon that, in the case where an opaque back electrode is divided into plural portions, a divided pattern of the back electrodes is displayed on a display surface due to an external light beam incident from the display surface, and which can also prevent the occurrence of such a phenomenon that, in the case where an opaque metal film is coated on a transparent electrode to design a light emitting area, an emitted light beam emitted from an organic layer leaks from an area except for the light emitting area.

In order to solve the aforesaid problem, according to a first aspect of the invention, there is provided an organic EL display apparatus wherein an opaque metal film is formed on a transparent electrode formed on a rear surface of a transparent substrate so as to form a window portion defining alight emitting area, then an organic layer is laminated thereon, and an opaque back electrode is formed on the organic layer so as to be divided in plural portions in correspondence to the metal films, the organic EL display apparatus is arranged in a manner that a metal reflection film is formed at an area which locates between the metal films on the rear surface of the transparent substrate and which covers at least a dividing slit between the back electrodes from a front surface side in a manner that the metal reflection film does not electrically connect between the metal films.

According to a second aspect of the invention, in the organic EL display apparatus according to the first aspect, the reflection film is also formed at a peripheral area of the metal film so that the metal films and the reflection film are disposed over almost an entire area of the light emitting area of a display screen except for the window portion.

According to a third aspect of the invention, in the organic EL display apparatus according to the first aspect, a distance between the metal film and the reflection film adjacent thereto is set to be equal to or less than 0.1mm.

### BRIEF DESCRIPTION OF THE DRAWINGS

Fig. 1 is a plan view of an organic EL display apparatus according to a first embodiment of the invention.

Fig. 2 is a sectional view of the apparatus cut along a line II-II in Fig. 1;

Fig. 3 is a sectional view for explaining a modified example of the first embodiment of the invention;

Fig. 4 is a plan view for explaining the modified example of the first embodiment of the invention; and

Fig. 5 is a sectional view of a conventional organic EL display apparatus.

### DETAILED DESCRIPTION OF THE PREFERRED EMBODIMENTS

Now, a description will be given in more detail of preferred embodiments of the invention with reference to the accompanying drawings.

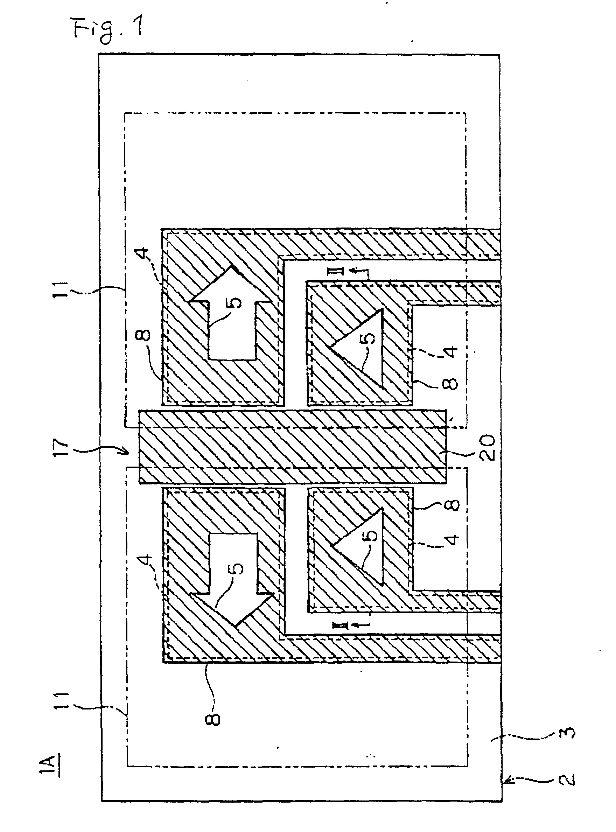

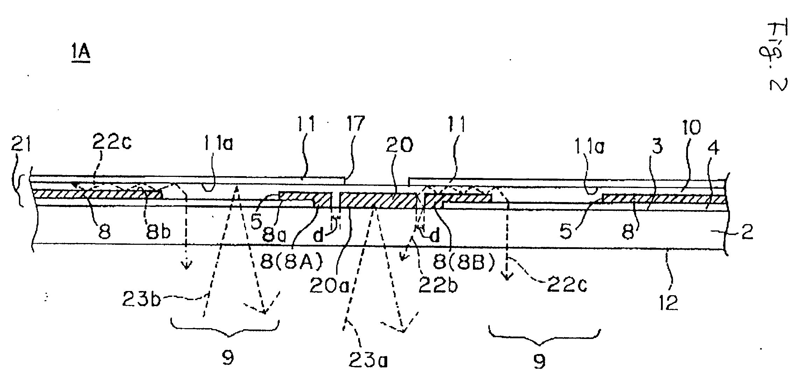

The organic EL display apparatus according to the first embodiment of the invention will be explained with reference to Figs. 1 and 2. Fig. 1 is a plan view of the organic EL display apparatus according to the embodiment and Fig. 2 is a sectional view of the apparatus cut along a line II-II in Fig. 1.

As shown in Figs . 1 and 2, in the organic EL display apparatus 1A according to the embodiment, an organic EL element 21 is configured in a manner that a transparent electrode 4 divided in corresponding to light emitting areas 9 is formed on the rear surface 3 of a transparent substrate 2 such as a glass substrate, for example, then opaque metal films 8 (made of chrome, aluminum etc., for example) with a small work function are coated on the transparent electrodes so as to form window portions 5 which define the light emitting areas 9 on the transparent electrodes 4, respectively, then a reflection film 20 made of metal is formed between the metal films 8 so as not to electrically connect these metal films 8 to each other, then an organic layer 10 is laminated thereon so as to coat them, and an opaque back electrode 11 divided in plural portions is formed on the organic layer so as to correspond to the metal films 8, respectively. Then, the organic EL display apparatus is formed by providing a not-shown sealing portion on the transparent substrate 2 so as to seal the organic EL element 21.

The reflection film 20 is formed on the rear surface 3 of the transparent substrate 2 so as to cover at least a dividing slit 17 between the back electrodes 11 from the front surface side of the slit (in Figs. 1 and 2, the reflection film 20 is formed so as to cover only the dividing slit 17). In this case, a distance (slit) d between the reflection film 20 and the metal films 8 adjacent to this reflection film 20 is set to be equal to or less than 0.1mm or, preferably, equal to or less than 0.03mm so that the reflection film and the metal film are not connected electrically to each other, and further so that, when a part 22b of light beams 22b and 22c emitted from the organic EL element 21 passes through the slit d and leaks to the outside through the display surface 12, a light intensity of the leaked light beam is reduced to a degree insufficient for recognizing visually. In this case, the metal film used for the reflection film 20 is preferably a metal film with a work function of 4.8eV or less, for example, made of chrome, aluminum, copper, titanium or the like. The metal film used as the reflection film 20 may be subjected to the oxidation treatment to a predetermined depth from the surface thereof.

The reflection film 20 is formed in a manner that the front surface 20a thereof is formed in a mirror surface state having the similar reflection ability as the front surface lla of the back electrode 11. Thus, since the dividing slit 17 between the back electrodes 11 is covered from the front side thereof by the reflection film 20, a mirror surface covering the entire area of the display surface 12 when viewed from the front side of the display surface 12 is configured by the front surface lla of the back electrode 11, the front surface 8a of the metal film 8 and the front surface 20a of the reflection film 20. Due to the presence of this mirror surface, external light beams 23a, 23b incident from the front surface (display surface) 12 of the transparent substrate 2 is mirror-reflected uniformly without any gap toward the display surface 12 side.

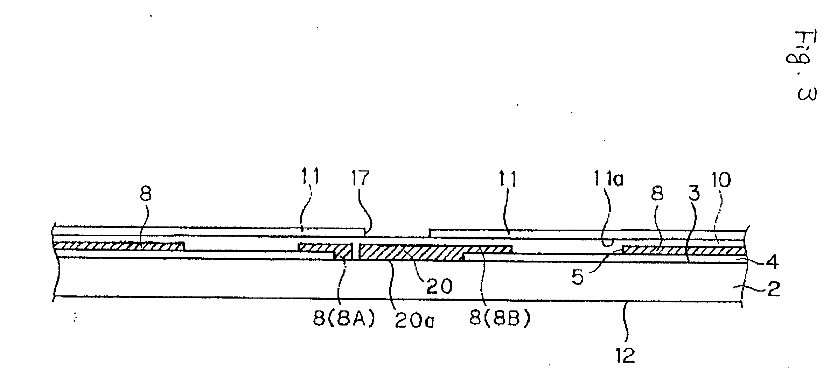

As shown in Fig. 3, the reflection film 20 may be integrally formed with one of metal films 8A and 8B adjacent thereto (in Fig. 3, the reflection film is integrally formed with the metal film 8B, for example) . That is, one of the metal films 8A and 8B may be extensively formed so as to cover the dividing slit 17 between the back electrodes 11 at least from the front surface side thereof.

Such an organic EL element 21 is fabricated in the following manner. That is, the pattern of the transparent electrodes 4 and the pattern of the metal films 8 are formed on the transparent substrate 2 by using ITO (indium tin oxide) etc. by means of the etching process etc. using the photo lithography, and then the transparent substrate 2 is washed by boiling surfactant, isopropanol etc.

Then, the organic layer 10 is formed by sequentially laminating, from the transparent electrodes 4 side, copper phthalocyanine serving as a hole injectionlayer with a thickness of 400 angstroms, α-NPD serving as a hole carrying layer with a thickness of 400 angstroms, aluminum quinoline complex (Alq3) added with 0.4 % (volume percent or volume fraction) of dimethyl quinacridone serving as an electron carrying light-emitting layer with a thickness of 600 angstroms, and lithium fluoride serving as an electron injection layer with a thickness of 10 angstroms. In the figures, the hole injection layer, the hole carrying layer, the electron carrying light-emitting layer and the electron injection layer are not separately shown.

Then, on the electron injection layer, MgAg alloy, Ca-Al, LiF-Al or Al etc. serving as the back electrodes 11 is formed with a thickness of 1000 angstroms so as to be distributed in plural areas by using a shadow mask. Each of the organic layer 10 and the back electrode 11 is formed in a film shape by the vacuum evaporation method using the resistor heating.

The driving method of the organic EL element 21 employs the time-division driving method. To this end, the back electrode 11 is divided in the plural portions. The transparent electrode 4 is connected to a power supply,through a not-shown switch serving as a column selector. On the other hand, the back electrode 11 is grounded through a switch serving as a row selector. According to this driving method, in the case of lighting each of the respective light emitting areas 9, it is merely required to turn on the switch for the power supply of the transparent electrode 4 and to turn on the switch corresponding to the back electrode 11 corresponding to the light emitting area 9. Accordingly, the organic layer 8 corresponding to the selected transparent electrode 4 and the back electrode 11 is lightened at the light emitting area 9 thereof to thereby display the segment thereof.

As the sealing portion, one formed by using glass member, for example, is employed. Such a sealing portion is fixed on the transparent substrate 2 in the following manner. That is, not-shown adhesive agent such as UV hardenable epoxy resin (3025G fabricated by Three Bond Co. ) is coated on a not-shown adhesive portion formed at the not-shown peripheral portion of the sealing portion with a width of about 0.5mm by using a dispenser . Then, the sealing portion is attached with a pressure to the transparent substrate 2 so as to cover the organic EL element 21. In this state, UV light from a high-pressure mercury lamp, for example, is radiated on the sealing portion at the light intensity of 4000mJ/cm² to thereby harden the adhesive agent, thereby fixing the sealing potion on the transparent substrate.

According to the organic EL display apparatus 1A configured in this manner, the reflection film 20 is formed between the metal films 8 on the rear surface 3 of the transparent substrate 2 so as not to electrically connect the adjacent metal films 8 to each other and so as to cover at least the dividing slit 17 between the back electrodes 11 from the front surface side. Thus, the mirror surface covering the entire area of the display surface 12 when viewed from the front side of the display surface 12 is configured by the front surface lla of the back electrode 11, the front surface 8a of the metal film 8 and the front surface 20a of the reflection film 20. Thus, the front surface of the reflection film and the front surface of the back electrode form the mirror surface covering the entire area of the display surface when viewed from the front side of the display surface. Accordingly, of the external light beams 23a, 23b incident within the organic EL display apparatus 1A from the display surface 12, not only the beam (the external light beam 23b) reflected by the front surface lla of the back electrode 11 and the front surface 8a of the metal film 8 is radiated on the display surface 12 side, but also the beam (the external light beam 23a) incident toward the dividing slit 17 between the back electrodes 11 is reflected by the front surface 20a of the reflection film 20 like the front surface lla of the back electrode 11 and the front surface 8a of the metal film 8 and then radiated on the display surface 12 side. Therefore, since the light intensity of the area of the display surface 12 corresponding to the back electrode 11 becomes almost same as that of the area of the display surface 12 corresponding to the dividing slit 17, such a phenomenon can be prevented from occurring that the divided pattern of the back electrodes 11 is displayed on the display surface 12, whereby the visibility of the displayed information can be improved.

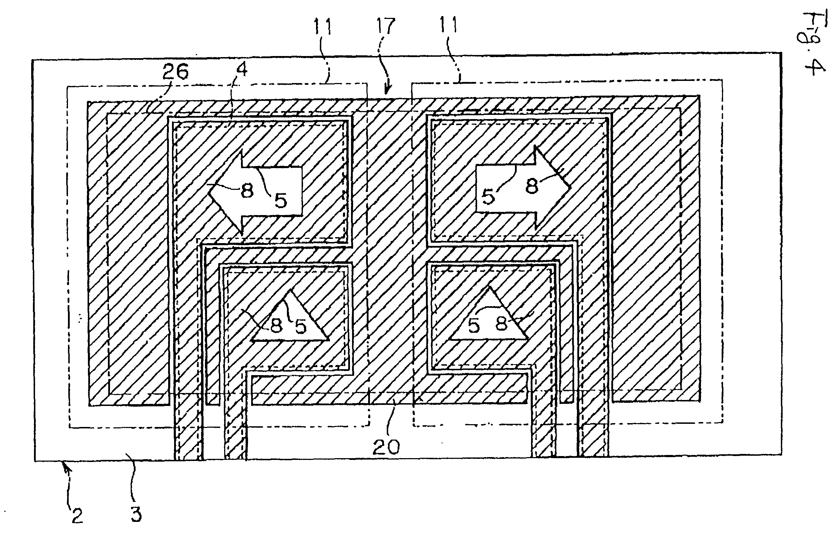

In this embodiment, as shown in Figs . 1 and 2, the explanation has been made as to the case where the reflection film 20 is formed on the rear surface 3 of the transparent substrate 2 so as to cover the dividing slit 17 between the back electrodes 11 from the front surface side. However, as shown in Fig. 4, not only the reflection film 20 is formed so as to cover the dividing slit 17 between the back electrodes 11 from the front surface side, but also the reflection film may be formed at the peripheral areas of the respective metal films 8 and further may be formed so as to cover an area (an area surrounded by a dot-and-dashed line in Fig. 4) of the rear surface 3 of the transparent substrate 2 which overlaps with at least the range forming the display screen. In this case, like the aforesaid case, a distance (slit) between the reflection film 20 formed at the peripheral area of the metal film 8 and the metal films 8 adjacent to this reflection film 20 is set to be equal to or less than 0.1mm or, preferably, equal to or less than 0.03mm.

According to such a configuration, the metal films 8 and the reflection films 20 are disposed over almost the entire area of the display screen except for the window portions 5 defining the light emitting areas 9. Thus, when the driving voltage is applied to the element to emit the light from the organic layer 10, even if a part 22c (see Fig. 2) of the emitted light beam enters between the back electrode 11 and the metal film 8, then is mirror-reflected by the front surface lla of the back electrode 11 and the rear surface 8b of the metal film 8 and induced to the peripheral area (an area except for the light emitting area) of the metal film 8, the light beam thus induced can be prevented from being leaked to the display screen side due to the provision of the reflection film 20 formed at the peripheral area of the metal film 8, whereby the display quality can be improved.

According to the first aspect of the invention, the reflection film is formed between the metal films on the rear surface of the transparent substrate to cover at least the dividing split between the back electrodes from the front surface side so as not to electrically connect the metal films to each other. Thus, the front surface of the reflection film and the front surface of the back electrode form the mirror surface covering the entire area of the display surface when viewed from the front side of the display surface. Accordingly, of the external light beams incident within the organic EL display apparatus from the display surface, not only the beam (the external light beam) reflected by the front surface of the back electrode and the front surface of the metal film is radiated on the display surface side, but also the beam (the external light beam) incident in the dividing slit between the back electrodes is reflected by the front surface of the reflection film like the front surface of the back electrode and the front surface of the metal film and then radiated on the display surface side. As a result, since the light intensity of the area of the display surface corresponding to the back electrode becomes almost same as that of the area of the display surface corresponding to the dividing slit, such a phenomenon can be prevented from occurring that the divided pattern of the back electrodes is displayed on the display surface, whereby the visibility of the displayed information can be improved.

According to the second aspect of the invention, the reflection film is also formed at the peripheral area of the metal film so that the metal films and the reflection film are disposed over almost the entire area of the light emitting area of the display screen except for the window portion. Thus, when the light is emitted from the organic layer, even if a part of the emitted light beam enters between the back electrode and the metal film, then is mirror-reflected by the front surface of the back electrode and the rear surface of the metal film and induced to the peripheral area (an area except for the light emitting area) of the metal film, the light beam thus induced can be prevented from being leaked to the display screen side due to the provision of the reflection film formed at the peripheral area of the metal film, whereby the display quality can be improved.

According to the third aspect of the invention, since the distance between the metal film and the reflection film adjacent thereto is set to be equal to or less than 0.1mm, such a phenomenon can be prevented from occurring that the metal film and the reflection film are electrically connected to each other to thereby erroneously emit light. Further, when a part of the light beam emitted from the organic layer leaks from the slit between the metal film and the reflection film to the display surface (display screen) side, since the leaked light can be reduced to a degree insufficient for recognizing visually, the display quality can be improved.

## Claims

1. An organic EL display apparatus, comprising:
a transparent substrate;
a transparent electrode formed on a rear surface of said transparent substrate;
an opaque metal film formed on said transparent electrode to form a window portion defining a light emitting area;
an organic layer laminated on said opaque metal film; and
an opaque back electrode formed on said organic layer so as to be divided in plural portions in correspondence to said metal films;
a metal reflection film formed at an area which locates between saidmetal films on said rear surface of said transparent substrate and which covers at least a dividing slit between said back electrodes from a front surface side so that said metal reflection film does not electrically connect between said metal films.

2. The organic EL display apparatus according to claim 1, wherein said reflection film is formed at a peripheral area of said metal film so that said metal films and said reflection film are disposed over almost an entire area of said light emitting area of a display screen except for said window portion.

3. The organic EL display apparatus according to claim 1, wherein a distance between said metal film and said reflection film adjacent thereto is set to be equal to or less than 0.1mm.
